# EUROPEAN PATENT APPLICATION

(11) **EP 3 118 725 A1**
(43) Date of publication of application: **18.01.2017**
(21) Application number: 16178326.1
(22) Date of filing: 07.07.2016
(51) Int. Cl.: G06F 3/01, G06T 13/40, G06F 17/50, A63F 13/55, A63F 13/42

(54) **WALK SIMULATION SYSTEM AND METHOD**

(30) Priority: 15.07.2015 US 201514800271
(71) Applicant: Siemens Product Lifecycle Management Software Inc., Plano, TX 75024-6612 (US)
(72) Inventor: Raschke, Ulrich, Ann Arbor, MI Michigan 48103 (US); Tirumali, Hrishikesh, Ann Arbor, MI Michigan 48105 (US)
(74) Representative: Isarpatent

(57) **Abstract**

A system (100) and method is provided that facilitates visualization and control of a simulation of walking in a manufacturing, work, or other human activity environment. The system may include at least one processor (102), at least one input device (110), a data store (112) including anthropometric data (114), and a display device (108). The input device may be used to receive first motion inputs (116). The processor may be configured to determine positions for foot falls (204) on a simulated support surface (206) that the feet (208) of a human figure (202) based on the anthropometric data will step on when being animated to walk on the support surface along a path (210) determined dynamically in real-time responsive to the first motion inputs. Based on the determined positions for the foot falls, the processor may generate a visual animation (200) through the display device of the human figure walking along the path in real time with the feet of the human figure being placed on the determined positions for the foot falls.

## Description

### TECHNICAL FIELD

The present disclosure is directed, in general, to computer-aided design, visualization, and manufacturing systems, product data management (PDM) systems, product lifecycle management (PLM) systems, and similar systems, that are used to create and manage data for products and other items (collectively referred to herein as product systems).

### BACKGROUND

PLM systems may include a graphical user interfaces (GUI) through which a manufacturing and/or a work environment may be simulated. Such graphical user interfaces may benefit from improvements.

### SUMMARY

Variously disclosed embodiments include systems and methods that may be used to visualize and control a simulation of walking in a manufacturing, work, or other human activity environment. In one example, a system may comprise: at least one input device through which first motion inputs are received; a data store including anthropometric data; a display device; and at least one processor. The at least one processor may be configured to determine positions for foot falls on a simulated support surface that the feet of a human figure, based on the anthropometric data, will step on when being animated to walk on the support surface along a path determined dynamically in real-time responsive to the first motion inputs. Based on the determined positions for the foot falls, the at least one processor may be configured to generate a visual animation through the display device of the human figure walking along the path in real time with the feet of the human figure being placed on the determined positions for the foot falls.

In another example, a method may include various acts carried out through operation of at least one processor. Such a method may include, through operation of at least one processor, receiving first motion inputs through an input device and anthropometric data for a simulated human figure from a data store. The method may also include, through operation of the at least one processor, determining positions for foot falls on a simulated support surface that the feet of the human figure, based on the anthropometric data, will step on when being animated to walk on the support surface along a path determined dynamically in real-time responsive to the first motion inputs. In addition, the method may include, through operation of the at least one processor, based on the determined positions for the foot falls, generating a visual animation through a display device of the human figure walking along the path in real-time with the feet of the human figure being placed on the determined positions for the foot falls.

A further example may include non-transitory computer readable medium encoded with executable instructions (such as a software component on a storage device) that when executed, causes at least one processor to carry out the described methods.

The foregoing has outlined rather broadly the technical features of the present disclosure so that those skilled in the art may better understand the detailed description that follows. Additional features and advantages of the disclosure will be described hereinafter that form the subject of the claims. Those skilled in the art will appreciate that they may readily use the conception and the specific embodiments disclosed as a basis for modifying or designing other structures for carrying out the same purposes of the present disclosure. Those skilled in the art will also realize that such equivalent constructions do not depart from the spirit and scope of the disclosure in its broadest form.

Before undertaking the Detailed Description below, it may be advantageous to set forth definitions of certain words or phrases that may be used throughout this patent document. For example, the terms "include" and "comprise," as well as derivatives thereof, mean inclusion without limitation. The singular forms "a", "an" and "the" are intended to include the plural forms as well, unless the context clearly indicates otherwise. Further, the term "and/or" as used herein refers to and encompasses any and all possible combinations of one or more of the associated listed items. The term "or" is inclusive, meaning and/or, unless the context clearly indicates otherwise. The phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like.

Also, although the terms "first", "second", "third" and so forth may be used herein to describe various elements, functions, or acts, these elements, functions, or acts should not be limited by these terms. Rather these numeral adjectives are used to distinguish different elements, functions or acts from each other. For example, a first element, function, or act could be termed a second element, function, or act, and, similarly, a second element, function, or act could be termed a first element, function, or act, without departing from the scope of the present disclosure.

In addition, phrases such as "processor is configured to" carry out one or more functions or processes, may mean the processor is operatively configured to or operably configured to carry out the functions or processes via software, firmware, and/or wired circuits. For example, a processor that is configured to carry out a function/process may correspond to a processor that is actively executing the software/firmware which is programmed to cause the processor to carry out the function/process and/or may correspond to a processor that has the software/firmware in a memory or storage device that is available to be executed by the processor to carry out the function/process. It should also be noted that a processor that is "configured to" carry out one or more functions or processes, may correspond to a processor circuit particularly fabricated or "wired" to carry out the functions or processes (e.g., an ASIC or FPGA design). Further the phrase "at least one" before an element (e.g., a processor) that is configured to carry out more than one function may correspond to one or more elements (e.g., processors) that each carry out the functions and may also correspond to two or more of the elements (e.g., processors) that respectively carry out different ones of the one or more different functions.

The term "adjacent to" may mean: that an element is relatively near to but not in contact with a further element; or that the element is in contact with the further portion, unless the context clearly indicates otherwise.

Definitions for certain words and phrases are provided throughout this patent document, and those of ordinary skill in the art will understand that such definitions apply in many, if not most, instances to prior as well as future uses of such defined words and phrases. While some terms may include a wide variety of embodiments, the appended claims may expressly limit these terms to specific embodiments.

### BRIEF DESCRIPTION OF THE DRAWINGS

Fig. 1 illustrates a functional block diagram of an example system that facilitates visualization and control of a simulation of walking.
Figs. 2 and 3 illustrate examples of foot fall positions that are determined for use with animating a human figure walking with feet placed on the determined foot fall positions.
Fig. 4 illustrates a flow diagram of an example methodology that facilitates visualization and control of a simulation of walking.
Fig. 5 illustrates a block diagram of a data processing system in which an embodiment can be implemented.

### DETAILED DESCRIPTION

Various technologies that pertain to drawing systems will now be described with reference to the drawings, where like reference numerals represent like elements throughout. The drawings discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged apparatus. It is to be understood that functionality that is described as being carried out by certain system components may be performed by multiple components. Similarly, for instance, a component may be configured to perform functionality that is described as being carried out by multiple components. The numerous innovative teachings of the present application will be described with reference to exemplary non-limiting embodiments.

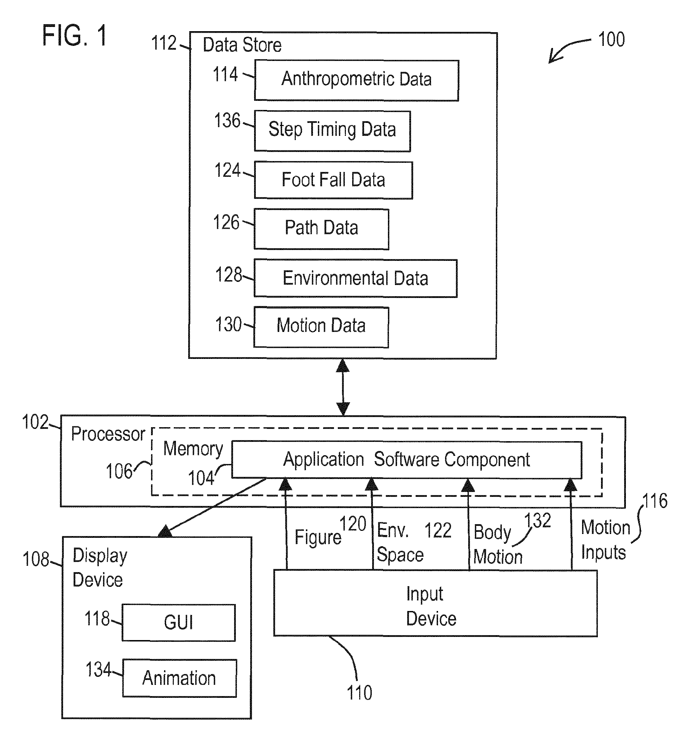

With reference to Fig. 1, an example system 100 that facilitates visualization and control of a simulation of walking is illustrated. The system 100 may include at least one processor 102 that is configured to execute one or more application software components 104 from a memory 106 in order to carry out the various features described herein. The application software component 104 that carries out the walking simulation may correspond to an independent application comprised of one or more components and/or may be integrated/included with software that carries out other functions.

Examples of PLM software and/or CAD/CAM/CAE (computer-aided design/computer-aided manufacturing/computer-aided engineering) software that may be adapted to include at least some of the functionality described herein for walk simulation includes the Teamcenter PLM and/or NX suites of applications that are available from Siemens Product Lifecycle Management Software Inc. (Plano, Texas). In particular, human simulation software such as Tecnomatix Jack human simulation software, available from Siemens Product Lifecycle Management Software Inc. may be adapted to include at least some of the functionality described herein.

However, it should also be understood the described application software component 104 that carries out walk simulation may correspond to or be integrated into other types of software, including but not limited to, architectural software, animation software, video games, mapping/travel software, and/or any other type of software that may have a use for simulated walking.

The described system may include at least one display device 108 (such as a display screen) and at least one input device 110. For example, the processor may included as part of a PC, notebook computer, workstation, server, tablet, mobile phone, or any other type of computing system. The display device, for example, may include an LCD display, monitor, and/ or a projector. The input devices, for example, may include an analog stick, d-pad, game controller, mouse, pointer, touch screen, touch pad, drawing tablet, track ball, buttons, keypad, keyboard, camera, motion sensing device that captures motion gestures, or any other type of input device capable of providing the inputs described herein. Also for devices such as a mobile phone or tablet, the processor 102 may be integrated into a housing that includes a touch screen that serves as both an input and display device. Further, it should be appreciated that some input devices may include a plurality of different types of input devices. For example, a game controller may include an analog stick, a d-pad, and a plurality of buttons.

However, it should be appreciated that example embodiments may use other types of input and display devices. Further it should be noted that the processor described herein may be located in a server that is remote from the display and input devices described herein. In such an example, the described display device and input device may be included in a client device that communicates with the server (and/or a virtual machine executing on the server) through a wired or wireless network (which may include the Internet). In some embodiments, such a client device, for example, may execute a remote desktop application or may correspond to a portal device that carries out a remote desktop protocol with the server in order to send inputs from an input device to the server and receive visual information from the server to display through a display device. Examples of such remote desktop protocols include Teradici's PCoIP, Microsoft's RDP, and the RFB protocol. In such examples, the processor described herein may correspond to a virtual processor of a virtual machine executing in a processor of the server.

In example embodiments, the system may further include a data store 112 (e.g., a memory, a relational database, a database server, a file on a storage device, or other structure that is operative to store information). The data store may include anthropometric data 114 stored therein for various types, sizes, and/or shapes of humans. Such anthropometric data may specify data that quantifies measurements of a human body, such as length, weight, and other sizes and/or dimensions of portions of a human body (e.g., legs, arms, torso) for a plurality of different types of humans (males, females, adults, children) and for a plurality of different size ranges of the humans. The data store 112 may also include step timing data 136 regarding the amount of time feet remain on and/or between foot fall positions for different types, sizes, and /or shapes of humans as well as for different types of motions (walking, fast walking, or other velocities of walking). Such step timing data, for example, may be based on empirical data gathered from studies of humans walking at different speeds for typical work place tasks or other activities.

The processor 102 may be configured (e.g., via the application software component 104) to dynamically (in real-time) produce an animation 134 of a particular human figure (i.e., an avatar) walking in directions based on motion inputs 116 with a stepping behavior that that is adapted to the anthropometric data 114 and step timing data 136 stored in the data store 112 with respect to the figure under analysis.

The processor 102 may be configured to receive such motion inputs 116 through the at least one input device 110. Such motion inputs may include direction data which provides information representative of a particular heading (i.e., an angular direction) or a change in heading (a degree of a direction change away from a current direction). For example, if the input device corresponds to a d-pad, direction inputs may correspond to heading directions such as: up, down, left, right, and diagonals such as upper-left, and lower-right. Further, an analog stick may provide finer inputs representative of degrees in a 360 degree circle for example. In addition, arrow keys may be used to provide direction change inputs from a keyboard where the amount of time an arrow key is pressed determines an amount of a direction change. Further mouse movements may be used to provide particular headings and/or changes in heading relative to a current heading, based on the direction a mouse is moved.

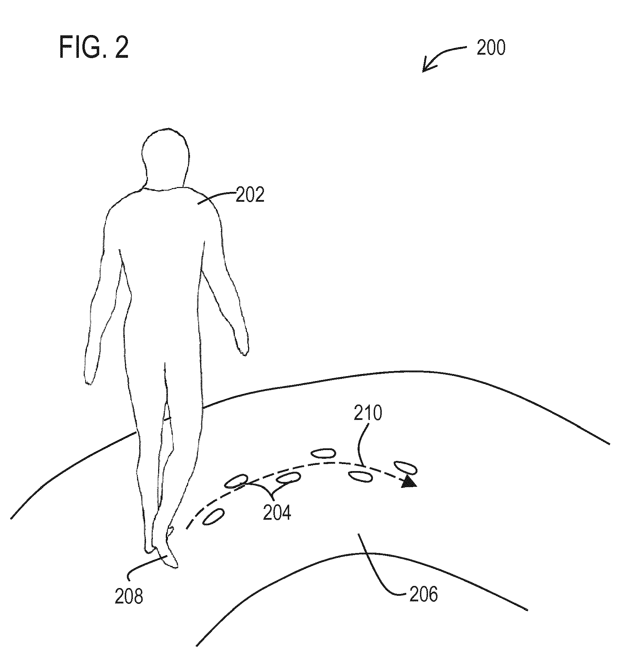

Fig. 2 illustrates an example snapshot of an animation 200 of a human figure 202 walking that is carried our responsive to motion inputs through at least one input device. In order to achieve an accurate modeling of the human figure walking relative to a particular environmental space (scene), the processor may be configured to determine positions for foot falls 204 on a simulated support surface 206 that the feet 208 of the human figure (based on the anthropometric data) will step on when being animated to walk on the support surface along a path 210. The processor in this example may be configured to change the path 210 dynamically in real-time along which the positions of the foot fall are determined to be placed responsive to direction data provided in the motion inputs. Then based on the determined positions for the foot falls, the processor may generate the visual animation 200 through the display device, which depicts the human figure 202 walking along the path 210 in real time with the feet 208 of the human figure being placed on the determined positions for the foot falls 204.

In some embodiments (such as shown in Fig. 2) the processor may be configured to cause the display device to display indicia (such as foot prints) at the determined positions of the foot falls 204. However, it should be appreciated that in other embodiments (or modes of operation of the application software component) the processor may not display indicia at the determined positions of the foot falls.

It should be appreciated that in example embodiments the foot fall positions may be based on algorithms of models of motions of humans that determine foot fall positions based on the anthropometric data (e.g., leg length data) and step timing data (e.g., times between steps) retrieved for a particular size/type of human figure walking at a speed of interest that is selected by a user. Examples of models of human motions that may be adapted to carry out the features described herein may include the Tecnomatix Jack human simulation software, available from Siemens Product Lifecycle Management Software Inc.

In addition, it should be appreciated that in some embodiments, portions of the anthropometric data and/or step timing data may interpolated using algorithms based on the size/type of human and/or walking speed selected to evaluate, and/or other anthropometric data and step timing data stored in the data store. Such algorithms usable by the described application software component may also be stored in one or more data stores.

Example embodiments enable a user of the system to evaluate human performance limitations as part of manufacturing planning where manual tasks are involved. The system may enable a user to select a particular type of human figure to evaluate and an environmental space in which to place the human figure. As illustrated in Fig. 1, the application software component 104 may enable a user via a graphical user interface (GUI) 118 to provide a figure selection input 120 and an environmental space input 122 through operation of the at least one input device 110.

For example, the GUI may provide the user with the ability to select a type of human (e.g., male, female, child), a size of the human (e.g., statistically normal, overweight, underweight, tall, short) or any other figure selection inputs that can be used by the application software component to select corresponding anthropometric data 114 from the data store for use with animating the figure. Also the GUI may provide the user with the ability to select an architectural file or CAD file for a desired environmental space. The processor may be configured to use the selected file to generate a 3-D depiction of the environmental space around the selected human figure. Such a selected environmental space may include the support surface 206 on which the human figure may walk.

In example embodiments, such an environmental space may correspond to a portion of an interior of a building (rooms, walls, equipment, manufacturing floor, hallways, work areas), an exterior area (walkways, building entrances, exits), portions of a user inhabited structure (bus, aircraft, or other vehicle), or any other type of space in which a human figure may walk along a path on a support surface. Further, it should be understood that the support surface may be comprised of a generally flat and level surface, as well as irregular surfaces with ramps and steps for example.

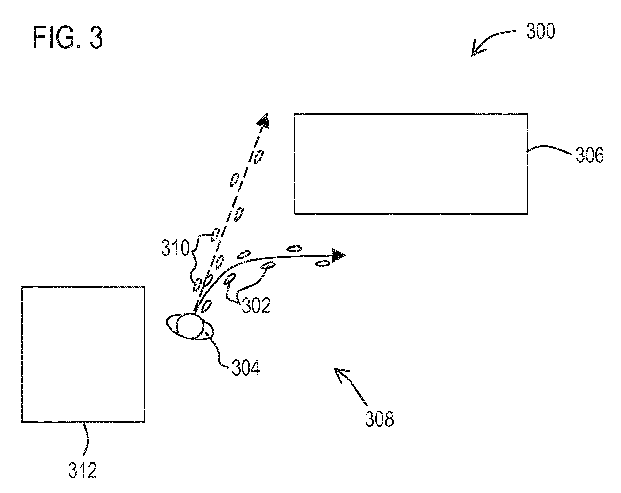

In example embodiments, such a support surface may have a sufficient size to make available a plurality of different paths for the human figure to walk along responsive to the motion inputs 116. For example, as illustrated in a downwardly directed view point 300 in Fig. 3, direction data (from the input device) associated with a change in heading towards the right, may cause the processor to determine foot falls 302 for a human figure 304 that will move the human figure rightward to the right of an object 306 in an environmental space 308. Whereas, if motion inputs from the input device remain unchanged and/or remain in the same forward direction, the processor may continue to determine foot falls 310 that would have moved the human figure in an alternative path straight ahead and the left of the object 306.

Referring back to Fig. 1, as the human figure is animated to walk responsive to the motion inputs, the processor may be configured to store determined foot fall data 124 and/or data corresponding to the path 126 of the foot fall positions in the data store 112 in association with the data corresponding to the particular environmental space 128 for which the foot fall positions were determined and in association with the particular anthropometric data used to determine the foot fall data. For example, such foot fall data 124 may include a foot fall history for step positions, number of steps, and step timing that was used to enable the human figure to move around the environmental space. Also for example, the path data 126 may correspond to the line of travel in the environmental space along which the foot falls were positioned to move the figure.

In addition, the processor may be configured to capture or determine other motion information 130 regarding the motion of the human figure and store such motion information in the data store 112. Such motion information may include walk distances, walk timing, posture changes, physiological limits, visibility, fatigue risk, and/or any other data impacted by the motion of the human figure for the different paths that the human figure is animated to walk along. Such information may be used in the process planning phase for an industrial engineering (time study) perspective, as well as an ergonomic (human performance) perspective. Further, the real-time determination of foot falls and the animation of the human figure enables the user of the system to experimentally "act out" different paths to achieve tasks and thereby enable individuals (who may not be capable of programming) to incorporate their own experience into the evaluation. Also, with a real-time control of human movements in a scene, a natural and quick exploration of design options is achievable. Numerous other advantages and benefits exist.

Example embodiments may further enable a user to provide body motion inputs 132 through the at least one input device 110 as well. Such body motion inputs 132 may be used to specify a change in a body posture of the human figure. For example, a change in body posture may include a direction of a head gaze (left, right, up, down) in order to look in a different direction (other than in the direction of the path). In example embodiments where the at least one input device corresponds to a game controller, such a game controller may include additional input devices such as an additional analog stick or d-pad which can be used by the user to provide body motion inputs (e.g., specifying a direction to move the head of the human figure) while simultaneously providing motion inputs via another analog stick or d-pad of the game controller.

The processor may be configured to change the direction of head gaze for the animated human figure responsive to the direction specified in such a body motion input, so that the user can cause the processor to depict what objects the animated figure may or may not be able to see while walking along the path. To enhance the ability of the user to perceive what the animated human figure will visually perceive, the application software component may enable the user to provide inputs through the input device that change the point of view of the user. For example, the user may switch the animation from depicting the body of the user (such as shown in Fig. 2) to a first person viewpoint that shows the view of a scene from the position of the eyes of the human figure. The processor may also be configured to display the human figure from other vantage points as well, such as an elevated downwardly directed view point 300 as illustrated in Fig. 3, or any other viewpoint that may be useful for evaluating the human figure in a scene.

Also, as illustrated in Fig. 3, the particular environmental space 308 that is selected may have a plurality of objects 306, 312 such as machinery, controls, and movable articles that may require various actions to be taken by an animated human figure 304 (e.g., reach out, duck, bend over, bend knees, raise arms). In example embodiments, the processor may be configured to be responsive to other types of body motion inputs through the input device to change the posture of the human figure to correspond to an orientation that can simulate such actions. For example, a d-pad, analog stick, and/or one or more buttons on the game controller may be associated with an action to pick up or set down an object or take some other action which may require the posture of the human figure to change (e.g., reaching with one or more arms for an object in a direction provided in the body motion inputs). For some posture changes, the processor may be operative to determine the position of the foot falls in view of such requested posture changes for the human figure as well as to cause the human figure to be animated so as to have a change in posture in real-time based on the body motion inputs.

In addition, in example embodiments, the processor may be configured to animate the figure so as to step to each foot fall in a manner that avoids skating (i.e., none natural movement along the path that would not be achievable via physical steps). For example, the processor may be configured to determine a sequence of three or more foot fall positions (before determining the animation for the human figure). The positions for such foot fall sequences may be determined to produce natural shuffle turns (in which the feet of the figure rotate/pivot to align them with a change in direction). However, it should be understood that for many walking motions, as few as a single next foot fall position may be determined prior to the processor modifying the animation of the human figure to step on such a determined single next foot fall position.

In addition, to minimize the amount of motion inputs required to direct the movement of the human figure, the described application software component may be configured to determine foot fall locations automatically based on the positions of some types of obstacles in the simulated environmental space and changes to the support surface (e.g., steps, ramps, poles).

It should be appreciated that input devices such as an analog stick, mouse, or touch pad may provide motion inputs that include not only include direction information but may also include magnitude information. For example, an analog stick may provide inputs representative of a displacement magnitude corresponding to an amount of distance that the slick is pushed from a center position. Also the displacement distance of a mouse pointer or displacement distance of a drag input on a touch screen may corresponds to information representative of a magnitude as well.

In example embodiments, the processor may be configured to change the pace (faster or slower) associated with the positions of the foot falls based on the magnitude information. Thus a higher magnitude (degree of push or displacement) may cause the processor to increase the distances between foot falls and/or increase the speed at which the feet are animated to step on the foot falls, in order to correspond to a person walking faster. However, in other embodiments the walking pace may be based on a statistically typical walking pace for the type and/or size of the human figure that is selected. Further, in other embodiments, the walking pace used to determine the foot falls may be configured and/or selected via the GUI. As discussed previously the processor may be configured to use step timing data based on empirical studies to determine the amount of time that the feet remain on and/or between steps for the particular pace of motion selected by the user.

Example embodiments of the application software component may be configured to enable the data captured in the data store 112 to be re-used to in subsequent simulations of the human figure (or another selected human figure). For example, the GUI 118 may enable a user to replay the animation in which the originally selected human figure is animated along the path on the same foot falls determined previously. In this example, the GUI may be responsive to body motion inputs 132 in order to move the head of the user (or other inputs that change the viewpoint of the animation), so that the visibility of objects by the human figure in the environmental space can be evaluated as the human figure is automatically animated to move along the previously determined path.

In another example, the GUI may enable the user to select a different type and/or size of human to evaluate with respect to the path determined using the prior selected human figure. In this example, the application software component may determine foot falls along the previously determined path (from the path data 126 stored in the data store 112) that are appropriate for the anthropometric data for the particular new figure selected by the user. In addition, the application software component may animate the new figure in the environmental space so as to walk on the newly determined foot falls. As discussed previously the GUI may enable the user to provide body motion inputs in order move the head of the user (or other inputs that change the viewpoint of the animation), so that the visibility of objects by the new figure in the environmental space can be evaluated.

As discussed previously, the application software component may be configured to determine the desired direction of movement within the simulation environment space, based on the heading of the joystick relative to the current orientation of the human figure in the scene, and based on this determined direction of movement (and optional magnitude information) determine the next foot fall, or foot fall sequence. The foot fall data that is determined and stored in the data store, may include the positions where the figure will step, which leg to use, and how long the step is to take. The application software component may be configured to take into account standard gait time and the specific figure anthropometry such as leg length to determine this data. When the input device provides an input corresponding to a desire to change orientation at the current location, or side step, or otherwise requires a specific step sequence to be executed, the application software component may be configured to determine this sequence for foot falls based on empirical models of step behavior. Furthermore, if obstacles or other conditions restrict foot fall location, these are taken into account in the determination of the foot falls.

In example embodiments, the determined foot fall positions and foot step timing may be added to a persisted memory array. Once the foot fall is determined, a whole body target posture may be calculated for that foot fall location. This whole body posture reflects the figure anthropometry and any desired postural characteristics: examples include posture adaptation to carry an object, or transition into a reach task. Once this posture is determined, transition foot motions are calculated for the stance and swing of the legs.

Once the posture, location and foot motion behavior are calculated, an algorithm may used to interpolate the current posture joint angles to the predicted ones, using a clock timer to execute the motion at the desired real-world speed. Legs may be separately positioned such that the feet follow calculated gait swing trajectories. Arms may be positioned to meet any arm swing or object task requirements. In addition, at each interpolation step, a callout to read the input devices for such body motion inputs such as eye gaze direction are interpreted, and realized. For example, as described previously the head of the human figure may be is oriented to the desired gaze direction provided in the body motion input.

The foot fall, path, and/or motion data 124, 126, 130 determined by the system may be of value to industrial engineers for such things as optimizing work areas by reducing non-value added movements (lean manufacturing), understand staffing requirements to keep up with production, and reducing risk of operator fatigue. The described system which provides an input device such as a game controller coupled with predictive step determination functionality (i.e., foot fall determination and step motion timing based on the selected figure anthropometry and empirical step behavior models) embodies an inexpensive, robust and flexible interface that may be integrated into any type of industrial design tool where human tasks are of interest.

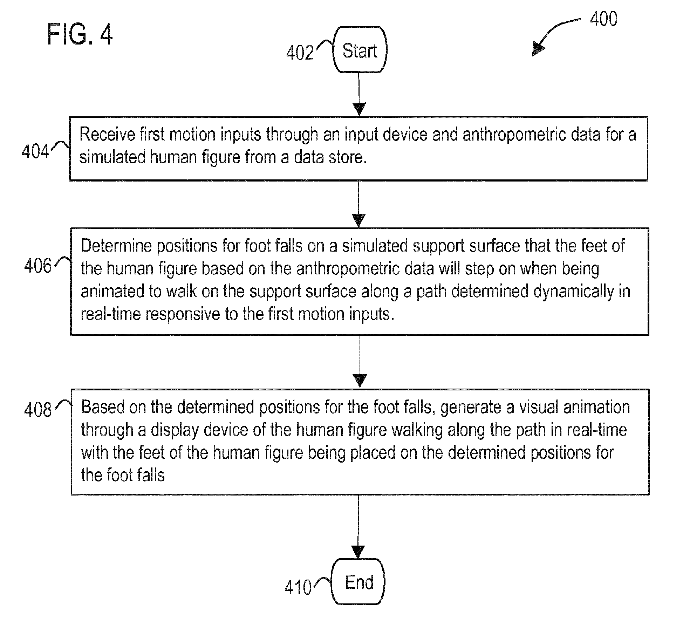

With reference now to Fig. 4, various example methodologies are illustrated and described. While the methodologies are described as being a series of acts that are performed in a sequence, it is to be understood that the methodologies may not be limited by the order of the sequence. For instance, some acts may occur in a different order than what is described herein. In addition, an act may occur concurrently with another act. Furthermore, in some instances, not all acts may be required to implement a methodology described herein.

It is important to note that while the disclosure includes a description in the context of a fully functional system and/or a series of acts, those skilled in the art will appreciate that at least portions of the mechanism of the present disclosure and/or described acts are capable of being distributed in the form of computer-executable instructions contained within non-transitory machine-usable, computer-usable, or computer-readable medium in any of a variety of forms, and that the present disclosure applies equally regardless of the particular type of instruction or signal bearing medium or storage medium utilized to actually carry out the distribution. Examples of non-transitory machine usable/readable or computer usable/readable mediums include: ROMs, EPROMs, magnetic tape, floppy disks, hard disk drives, SSDs, flash memory, CDs, DVDs, and Blu-ray disks. The computer-executable instructions may include a routine, a sub-routine, programs, applications, modules, libraries, a thread of execution, and/or the like. Still further, results of acts of the methodologies may be stored in a computer-readable medium, displayed on a display device, and/or the like.

Referring now to Fig. 4, a methodology 400 that facilitates visualization and control of a simulation of walking is illustrated. The method may start at 402 and the methodology may include several acts carried out through operation of at least one processor. These acts may include an act 404 of receiving first motion inputs through an input device and anthropometric data for a simulated human figure from a data store. These acts may also include an act 406 of determining positions for foot falls on a simulated support surface that the feet of the human figure based on the anthropometric data will step on when being animated to walk on the support surface along a path determined dynamically in real-time responsive to the first motion inputs. In addition these acts may include an act 408 of based on the determined positions for the foot falls, generating a visual animation through a display device of the human figure walking along the path in real-time with the feet of the human figure being placed on the determined positions for the foot falls. At 410 the methodology may end.

In addition, the methodology 400 may include other acts and features discussed previously with respect to the system 100. For example, the first motion inputs may include information representative of a change in direction from a first direction to a second direction. Also the act 406 may include an act of being responsive to the information representative of a change in direction, in order to determine positions for a step sequence of the foot falls on the simulated support surface that will cause the body of the human figure to rotate as the feet of the human figure are visually animated to step on the further foot falls and cause the human figure to change from walking in alignment with the first direction to walking in alignment with the second direction.

In this described methodology, the motion inputs may include information representative of a magnitude and a direction. Also, the anthropometry data may include leg length data for the human figure and the data store may further include step timing data. In addition the methodology 400 may include the act of determining the positions of the foot falls, which foot of the human figure that is placed on the position of each foot fall, and an amount of time each foot remains on each foot fall, based at least in part on both the magnitude and direction information received from the at least one input device, the anthropometry data including the leg length data, and the step timing data.

In addition the methodology may include an act in which responsive to a body motion input through the at least one input device, the at least one processor determines changes to the posture of the human figure as the human figure is animated to walk along the path. In this example, the visual animation of the human figure walking may be generated based at least in part on the determined changes to the posture of the human figure.

Also, in some examples, the foot falls may be determined responsive to the determined changes to the posture of the human figure. However, in other examples, the foot falls may not change based on the changes to the posture of the human figure.

In example embodiments, the determined changes to the posture of the human figure may include: the human figure turning their head so that the eyes of the human figure are directed towards the direction provided by the body motion input; the human figure ducking so as to lower the height of the human figure; and/or the human figure reaching with at least one arm to simulate reaching for an object in a direction provided by the body motion input

As discussed previously, the view point for the generation of the animation may be user changeable. Thus when the system is in a mode to output a first person view of the scene from the view point of the eyes of the human figure, a posture change that includes turning the head of the human figure via body motion inputs may allow a user to better see objects around the human figure.

Example embodiments of the described methodology 400 may also include an act of causing the display device to output a visual representation of a plurality of objects along the path (e.g., steps, ramps, poles). In this example, the positions of the foot falls may be further determined based at least in part on the objects.

Further, the described methodology 400 may include an act of storing information representative of the determined foot falls including the position of the foot falls and time data for each step in the data store in correlated relation with information representative of the anthropometric data for the human figure.

In addition, the described methodology 400 may include an act of generating a further visual animation through the display device of the human figure walking along the path with the feet of the human figure being placed on the determined positions for the foot falls based on the information representative of the determined foot falls stored in the data store.

Example embodiments of the described methodology may also include an act of receiving an input representative of a prompt to modify the simulated human figure from being based on first anthropometric data to being based on second anthropometric data, wherein the second anthropometric data specifies that the simulated human figure has a different size than that specified by the first anthropometric data. Further the methodology may include the act of determining alternative positions for the foot falls on the simulated support surface that the feet of the modified human figure based on the second anthropometric data will step on when being animated to walk on the support surface along the path that was previously determined based on the first motion inputs. In addition the methodology may include, based on the determined alternative positions for the foot falls, generating a visual animation through the display device of the modified human figure walking along the path with the feet of the modified human figure being placed on the determined alternative positions for the foot falls.

As discussed previously, such acts associated with these methodologies may be carried out by one or more processors. Such processor(s) may be included in one or more data processing systems, for example, that execute software components operative to cause these acts to be carried out by the one or more processors. In an example embodiment, such software components may be written in software environments/languages/frameworks such as Java, JavaScript, Python, C, C#, C++ or any other software tool capable of producing components and graphical user interfaces configured to carry out the acts and features described herein.

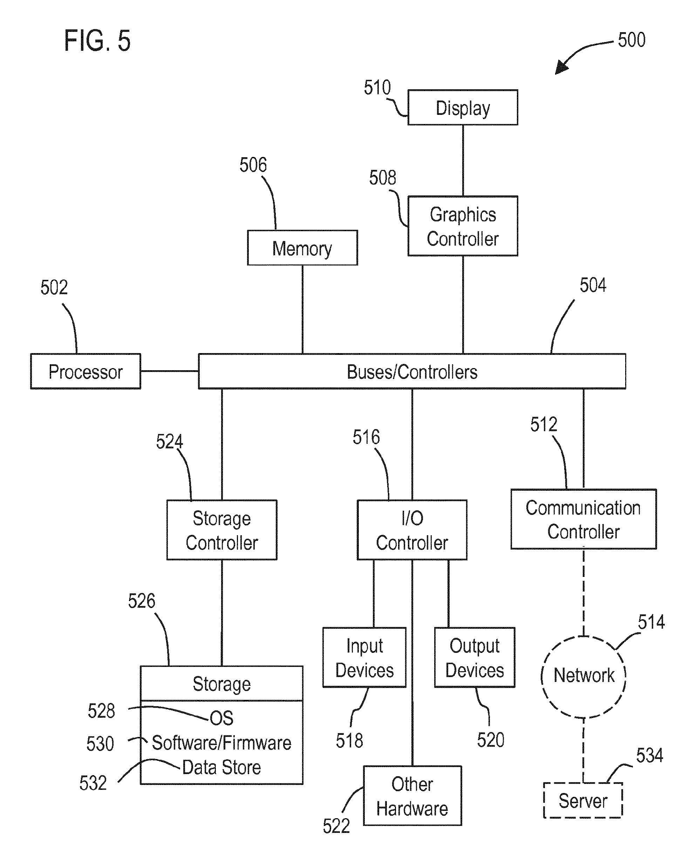

Fig. 5 illustrates a block diagram of a data processing system 500 (also referred to as a computer system) in which an embodiment can be implemented, for example, as a portion of a PLM, CAD, and/or other system operatively configured by software or otherwise to perform the processes as described herein. The data processing system depicted includes at least one processor 502 (e.g., a CPU) that may be connected to one or more bridges/controllers/buses 504 (e.g., a north bridge, a south bridge). One of the buses 504, for example, may include one or more I/O buses such as a PCI Express bus. Also connected to various buses in the depicted example may include a main memory 506 (RAM) and a graphics controller 508. The graphics controller 508 may be connected to one or more display devices 510. It should also be noted that in some embodiments one or more controllers (e.g., graphics, south bridge) may be integrated with the CPU (on the same chip or die). Examples of CPU architectures include IA-32, x86-64, and ARM processor architectures.

Other peripherals connected to one or more buses may include communication controllers 512 (Ethernet controllers, WiFi controllers, cellular controllers) operative to connect to a local area network (LAN), Wide Area Network (WAN), a cellular network, and/or other wired or wireless networks 514 or communication equipment.

Further components connected to various busses may include one or more I/O controllers 516 such as USB controllers, Bluetooth controllers, and/or dedicated audio controllers (connected to speakers and/or microphones). It should also be appreciated that various peripherals may be connected to the USB controller (via various USB ports) including input devices 518 (e.g., keyboard, mouse, touch screen, trackball, gamepad, camera, microphone, scanners, motion sensing devices), output devices 520 (e.g., printers, speakers) or any other type of device that is operative to provide inputs or receive outputs from the data processing system. Further it should be appreciated that many devices referred to as input devices or output devices may both provide inputs and receive outputs of communications with the data processing system. Further it should be appreciated that other peripheral hardware 522 connected to the I/O controllers 516 may include any type of device, machine, or component that is configured to communicate with a data processing system.

Additional components connected to various busses may include one or more storage controllers 524 (e.g., SATA). A storage controller may be connected to a storage device 526 such as one or more storage drives and/or any associated removable media, which can be any suitable non-transitory machine usable or machine readable storage medium. Examples, include nonvolatile devices, volatile devices, read only devices, writable devices, ROMs, EPROMs, magnetic tape storage, floppy disk drives, hard disk drives, solid-state drives (SSDs), flash memory, optical disk drives (CDs, DVDs, Blu-ray), and other known optical, electrical, or magnetic storage devices drives and/or computer media. Also in some examples, a storage device such as an SSD may be connected directly to an I/O bus 504 such as a PCI Express bus.

A data processing system in accordance with an embodiment of the present disclosure may include an operating system 528, software/firmware 530, and data stores 532 (that may be stored on a storage device 526 and/or the memory 506). Such an operating system may employ a command line interface (CLI) shell and/or a graphical user interface (GUI) shell. The GUI shell permits multiple display windows to be presented in the graphical user interface simultaneously, with each display window providing an interface to a different application or to a different instance of the same application. A cursor or pointer in the graphical user interface may be manipulated by a user through a pointing device such as a mouse or touch screen. The position of the cursor/pointer may be changed and/or an event, such as clicking a mouse button or touching a touch screen, may be generated to actuate a desired response. Examples of operating systems that may be used in a data processing system may include Microsoft Windows, Linux, UNIX, iOS, and Android operating systems. Also, examples of data stores include data files, data tables, relational database (e.g., Oracle, Microsoft SQL Server), database servers, or any other structure and/or device that is capable of storing data which is retrievable by a processor.

The communication controllers 512 may be connected to the network 514 (not a part of data processing system 500), which can be any public or private data processing system network or combination of networks, as known to those of skill in the art, including the Internet. Data processing system 500 can communicate over the network 514 with one or more other data processing systems such as a server 534 (also not part of the data processing system 500). However, an alternative data processing system may correspond to a plurality of data processing systems implemented as part of a distributed system in which processors associated with several data processing systems may be in communication by way of one or more network connections and may collectively perform tasks described as being performed by a single data processing system. Thus, it is to be understood that when referring to a data processing system, such a system may be implemented across several data processing systems organized in a distributed system in communication with each other via a network.

Further, the term "controller" means any device, system or part thereof that controls at least one operation, whether such a device is implemented in hardware, firmware, software or some combination of at least two of the same. It should be noted that the functionality associated with any particular controller may be centralized or distributed, whether locally or remotely.

In addition, it should be appreciated that data processing systems may be implemented as virtual machines in a virtual machine architecture or cloud environment. For example, the processor 502 and associated components may correspond to a virtual machine executing in a virtual machine environment of one or more servers. Examples of virtual machine architectures include VMware ESCi, Microsoft Hyper-V, Xen, and KVM.

Those of ordinary skill in the art will appreciate that the hardware depicted for the data processing system may vary for particular implementations. For example, the data processing system 500 in this example may correspond to a computer, workstation, and/or a server. However, it should be appreciated that alternative embodiments of a data processing system may be configured with corresponding or alternative components such as in the form of a mobile phone, tablet, controller board or any other system that is operative to process data and carry out functionality and features described herein associated with the operation of a data processing system, computer, processor, and/or a controller discussed herein. The depicted example is provided for the purpose of explanation only and is not meant to imply architectural limitations with respect to the present disclosure.

As used herein, the terms "component" and "system" are intended to encompass hardware, software, or a combination of hardware and software. Thus, for example, a system or component may be a process, a process executing on a processor, or a processor. Additionally, a component or system may be localized on a single device or distributed across several devices.

Also, as used herein a processor corresponds to any electronic device that is configured via hardware circuits, software, and/or firmware to process data. For example, processors described herein may correspond to one or more (or a combination) of a microprocessor, CPU, FPGA, ASIC, or any other integrated circuit (IC) or other type of circuit that is capable of processing data in a data processing system, which may have the form of a controller board, computer, server, mobile phone, and/or any other type of electronic device.

Those skilled in the art will recognize that, for simplicity and clarity, the full structure and operation of all data processing systems suitable for use with the present disclosure is not being depicted or described herein. Instead, only so much of a data processing system as is unique to the present disclosure or necessary for an understanding of the present disclosure is depicted and described. The remainder of the construction and operation of data processing system 500 may conform to any of the various current implementations and practices known in the art.

Although an exemplary embodiment of the present disclosure has been described in detail, those skilled in the art will understand that various changes, substitutions, variations, and improvements disclosed herein may be made without departing from the spirit and scope of the disclosure in its broadest form.

None of the description in the present application should be read as implying that any particular element, step, act, or function is an essential element which must be included in the claim scope: the scope of patented subject matter is defined only by the allowed claims. Moreover, none of these claims are intended to a means plus function claim construction unless the exact words "means for" are followed by a participle.

## Claims

1. A system (100) for visualization and control of a simulation of walking in a manufacturing, work, or other human activity environment comprising:
at least one input device (110) through which first motion inputs (116) are received;
a data store (112) including anthropometric data (114);
a display device (108); and
at least one processor (102) configured: to determine positions for foot falls (204) on a simulated support surface (206) that the feet (208) of a human figure (202) based on the anthropometric data will step on when being animated to walk on the support surface along a path (210) determined dynamically in real-time responsive to the first motion inputs; and based on the determined positions for the foot falls, generate a visual animation (200) through the display device of the human figure walking along the path in real time with the feet of the human figure being placed on the determined positions for the foot falls.

2. The system according to claim 1, wherein when first motion inputs include information representative of a change in direction from a first direction to a second direction, the at least one processor is responsive to the information representative of the change in direction to determine positions for a step sequence of the foot falls on the simulated support surface that will cause the body of the human figure to rotate as the feet of the human figure are visually animated to step on the foot falls and cause the human figure to change from walking in alignment with the first direction to walking in alignment with the second direction.

3. The system according to any one of claims 1 or 2, wherein the first motion inputs include information representative of a magnitude and a direction, wherein the anthropometry data includes leg length data, wherein the data store includes step timing data (136), wherein the at least one processor is configured to determine the positions of the foot falls, which foot of the human figure that is placed on the position of each foot fall, and an amount of time each foot remains on each foot fall, based at least in part on both the magnitude and direction information received from the at least one input device, the anthropometry data including the leg length data, and the step timing data.

4. The system according to any one of claims 1 to 3, wherein responsive to a body motion input (132) through the at least one input device, the at least one processor is configured to determine changes to the posture of the human figure as the human figure is animated to walk along the path, wherein the at least one processor is configured to generate the visual animation of the human figure walking based at least in part on the determined changes to the posture of the human figure, wherein the foot falls are determined responsive to the determined changes to the posture of the human figure.

5. The system according to any one of claims claim 1 to 3, wherein responsive to a body motion input (132) through the at least one input device, the at least one processor is configured to determine changes to the posture of the human figure as the human figure is animated to walk along the path, wherein the determined changes to the posture of the human figure include:
the human figure turning their head so that the eyes of the human figure are directed towards the direction provided by the body motion input;
the human figure ducking so as to lower the height of the human figure; and/or
the human figure reaching with at least one arm to simulate reaching for an object in a direction provided by the body motion input;
wherein the at least one processor is configured to cause the visual animation of the human figure to be generated with the determined changes to the posture of the human figure.

6. The system according to any one of claim 1 to 5,
wherein the at least one processor is configured to store information representative of the determined foot falls including the positions of the foot falls and time data for each step in a data store in correlated relation with information representative of the anthropometric data for the human figure,
wherein the at least one processor is configured to generate a further visual animation through the display device of the human figure walking along the path with the feet of the human figure being placed on the determined positions for the foot falls based on the information representative of the determined foot falls stored in the data store, and
wherein the at least one processor is configured to receive an input representative of a prompt to modify the simulated human figure from being based on first anthropometric data to being based on second anthropometric data, wherein the second anthropometric data specifies that the simulated human figure has a different size than that specified by the first anthropometric data, wherein based on the second anthropometric data, the at least one processor is configured to determine alternative positions for the foot falls on the simulated support surface that the feet of the modified human figure will step on when being animated to walk on the support surface along the path that was previously determined based on the first motion inputs, wherein the at least one processor is configured based on the determined alternative positions for the foot falls, to generate a visual animation through the display device of the modified human figure walking along the path with the feet of the modified human figure being placed on the determined alternative positions for the foot falls.

7. The system according to any one of claims 1 to 6, further comprising a computer system including a memory (106) an application software component (104), the at least one processor, the at least one input device and the display device, wherein the application software component is comprised of instructions that when included in the memory and executed by the at least one processor, cause the at least one processor to determine the foot falls based at least in part on the motion inputs from the input device and cause the display device to output the visual animation through the display device of the human figure walking along the path, wherein the at least one processor is configured to cause the display device to output a visual representation of a plurality of objects along the path, wherein the at least one processor is configured to determine the positions of the foot falls responsive at least in part to the objects.

8. A method for visualization and control of a simulation of walking in a manufacturing, work, or other human activity environment comprising:
through operation of at least one processor (102):
receiving first motion inputs (116) through an input device (110) and anthropometric data (114) for a simulated human figure (202) from a data store (112);
determining positions for foot falls (204) on a simulated support surface (206) that the feet (208) of the human figure based on the anthropometric data will step on when being animated to walk on the support surface along a path (210) determined dynamically in real-time responsive to the first motion inputs; and
based on the determined positions for the foot falls, generating a visual animation (200) through a display device (108) of the human figure walking along the path in real-time with the feet of the human figure being placed on the determined positions for the foot falls.

9. The method according to claim 8, wherein the first motion inputs include information representative of a change in direction from a first direction to a second direction, wherein determining the positions of the foot falls includes:
through operation of the at least one processor responsive to the information representative of a change in direction, determining positions for a step sequence of the foot falls on the simulated support surface that will cause the body of the human figure to rotate as the feet of the human figure are visually animated to step on the further foot falls and cause the human figure to change from walking in alignment with the first direction to walking in alignment with the second direction.

10. The method according to any one of claims 8 or 9, wherein the first motion inputs include information representative of a magnitude and a direction, wherein the anthropometry data includes leg length data, wherein the data store includes step timing data (136), further comprising determining the positions of the foot falls, which foot of the human figure that is placed on the position of each foot fall, and an amount of time each foot remains on each foot fall, based at least in part on both the magnitude and direction information received from the at least one input device, the anthropometry data including the leg length data, and the step timing data.

11. The method according to any one of claims 8 to 10, wherein responsive to a body motion input (132) through the at least one input device, through operation of the at least one processor:
determining changes to the posture of the human figure as the human figure is animated to walk along the path,
wherein the visual animation of the human figure walking is generated based at least in part on the determined changes to the posture of the human figure, and
wherein the foot falls are determined responsive to the determined changes to the posture of the human figure.

12. The method according to any one of claims 8 to 10, wherein responsive to a body motion input (132) through the at least one input device, through operation of the at least one processor:
determining changes to the posture of the human figure as the human figure is animated to walk along the path, wherein the determined changes to the posture of the human figure include:
the human figure turning their head so that the eyes of the human figure are directed towards the direction provided by the body motion input;
the human figure ducking so as to lower the height of the human figure; and/or
the human figure reaching with at least one arm to simulate reaching for an object in a direction provided by the body motion input; and
wherein the visual animation of the human figure walking is generated with the determined changes to the posture of the human figure.

13. The method according to any one of claims 8 to 12, further comprising through operation of the at least one processor causing the display device to output a visual representation of a plurality of objects (306, 312) along the path, wherein the positions of the foot falls are further determined based at least in part on the objects.

14. The method according to any one of claim 8 o 13, further comprising through operation of the at least one processor:
storing information representative of the determined foot falls including the positions of the foot falls and time data for each step in the data store in correlated relation with information representative of the anthropometric data for the human figure;
generating a further visual animation through the display device of the human figure walking along the path with the feet of the human figure being placed on the determined positions for the foot falls based on the information representative of the determined foot falls stored in the data store;
receiving an input representative of a prompt to modify the simulated human figure from being based on first anthropometric data to being based on second anthropometric data, wherein the second anthropometric data specifies that the simulated human figure has a different size than that specified by the first anthropometric data;
determining alternative positions for the foot falls on the simulated support surface that the feet of the modified human figure based on the second anthropometric data will step on when being animated to walk on the support surface along the path that was previously determined based on the first motion inputs; and
based on the determined alternative positions for the foot falls, generating a visual animation through the display device of the modified human figure walking along the path with the feet of the modified human figure being placed on the determined alternative positions for the foot falls.

15. A non-transitory computer readable medium encoded with executable instructions that when executed, cause the at least one processor to carry out the method according to any one of claims 8 to 14.
